# EUROPEAN PATENT APPLICATION

(11) **EP 1 863 100 A1**
(43) Date of publication of application: **05.12.2007**
(21) Application number: 06011050.9
(22) Date of filing: 30.05.2006
(51) Int. Cl.: H01L 31/18

(54) **Method for the production of thin substrates**

(71) Applicant: INTERUNIVERSITAIR MICROELEKTRONICA CENTRUM vzw (IMEC), 3001 Leuven (BE)
(72) Inventor: Dross, Frederic, 1030 Schaarbeek (BE); Van Kerschaver, Emmanuel, 3111 Wezemaal (BE); Beaucarne, Guy, 3050 Oud-Heverlee (BE)
(74) Representative: Bird, William Edward

(57) **Abstract**

The present invention is related to a method for producing a thin substrate, comprising
a. providing a mother substrate, the mother substrate having a first main surface;
b. inducing a predetermined amount of stress in at least a portion of the mother substrate, said portion comprising the thin substrate, the induced stress being locally larger than the toughness of the mother substrate;

such that the thin substrate is released from the mother substrate.

## Description

### Field of the invention

The present invention relates to the field of production of thin substrates.

### Background of the invention

Nowadays' production of solar cells mainly relies on silicon. Crystalline silicon solar cells (including multi-crystalline and single-crystal) account for 90% of solar cell production [http://www.epia.org]. But a major issue is currently threatening the impressive 40% annual growth of both market and production: the world of photovoltaics is currently undergoing a deep silicon feedstock shortage [Photon International]. In addition, the price of a commercially available silicon solar module is driven by the cost of the semiconductor material which represents by itself almost half of the production cost of the finished module. Furthermore, independently of the material price, with currently industrially achievable surface recombination velocities (~200 cm.s⁻¹), the optimum thickness for achieving the highest efficiency on a crystalline silicon solar cell lies in the range of 50 µm, a lot thinner than the currently available 250 µm-thick wafers. Moreover below a few tens of microns, silicon becomes flexible. Encapsulated in a suitable and flexible material, it can provide a building block for new applications requiring lightweight, flexible, high efficiency solar modules, such as energy generating clothes, ambient intelligence devices, solar vehicles, etc. These arguments favour, independently of one another, the development of cells and/or wafers as thin as possible.

At the moment, silicon wafering (e.g. for solar cells) is still performed by wire saw techniques, which bring an important kerf loss of around 200 µm per wafer. The relative loss is thus even increasing for thinner substrates.

Silicon ribbon technology (W. Koch et al., Proceedings Td World PVSEC. 1998, p. 1254, Photon International, June 2004, R Janoch, R Wallace, Jl Hanoka - CONFERENCE RECORD IEEE PHOTOVOLTAIC SPECIALISTS CONFERENCE, 1997), leads to the production of 150-µm-thick wafers. It is difficult to achieve thinner wafers with the conventional ribbon technologies. Moreover, the throughput of most ribbon technologies is low.

The Smart Cut technique relies on H+ implantation at a given depth in a wafer in order to weaken an underlying layer and detaching the top layer from its parent wafer. This technique is not cost competitive for solar applications [L. Shao et al., Applied Physics Letters 87, 091902, 2005, and S Bengtsson - Solid-State and Integrated Circuit Technology, 1998].

Other technologies ('lift-off or 'layer transfer' approaches) rely on the creation of a weaker layer (crystal mismatch, porous layer, defect-full layer), on which a crystalline silicon layer is grown. The grown layer is then detached from the parent layer. [R. Brendel, Jpn. J. Appl. Phys. Vol.40, Part 1, No. 7, 4431 (2001) ; C.S. Solanki, et al. (IMEC), Phys. Stat. Sol. (a), 182 (2000) 97; K. J. Weber et al., Appl. Phys. A, A69 (1999) 195] .

Another alternative takes benefit of the fact that the kerf loss is reduced when a laser is used to cut the wafers. A full-laser wafering technique has not been performed yet but only thin silicon slices (1-2 mm large) have been produced, which are not ideal for solar cells because of the complexity of the assembling of the solar module. [A.W. Blakers et al., "Recent development in Sliver Cell Technology", 20th European Photovoltaic Solar Energy Conference, 6-10 June 2005, Barcelona, Spain].

### Aim of the invention

It is an aim of this invention to provide for a method for producing thin substrates, which alleviates or avoids the problems of the prior art.

### Summary of the invention

A method for producing a thin substrate with a thickness below 750 µm is disclosed, the method comprising
providing a mother substrate comprising a material, the mother substrate having a first main surface;
inducing a predetermined amount of stress in at least a portion of the mother substrate, the portion comprising the thin substrate, the induced stress being locally larger than the toughness of the mother substrate;
such that the thin substrate is released from the mother substrate.

The toughness of a material is a measure of the resistance to fracture when stressed. Toughness is the value of the stress intensity at which fracture occurs in the case of cracks, as defined in the book "The practical use of fracture mechanics", David Broek, Kluwer Academic Publishers 1988.

The mother substrate, further simply called substrate (as contrary to the thin substrate, which is that part of the mother substrate which according to the present invention is lift off), can be a bulk or homogeneous substrate. In embodiments the substrate does not comprise local weaknesses when inducing a predetermined amount of stress. In certain embodiments no weakened planes are created in the substrate before inducing a predetermined amount of stress (e.g. no ion implantation, no porous layer, no crystalline mismatch).

The mother substrate can be made of any suitable material. In preferred embodiments, substrate materials can be semiconductor materials which can include, but are not limited to the following: Silicon (Si), Germanium (Ge), Gallium Phosphide (GaP), Gallium Arsenide (GaAs), Indium Arsenide (InAs), Diamond (C), Gallium Antimonide (GaSb), Indium Antimonide (InSb), Indium Phosphide (InP), Gallium Arsenide Antimonide (GaAs₁₋ₓSbₓ), Aluminum Gallium Arsenide (AlₓGa₁₋ₓAs), Gallium Indium Phosphide (Gaₓln₁₋ₓP), Gallium Indium Arsenide (Gaₓln₁₋ₓAs), Gallium Indium Antimonide (Gaₓln₁₋ₓSb), Indium Arsenide Antimonide (InAs₁₋ₓSbₓ), Gallium Indium Arsenide Phosphide (Gaₓln₁₋ₓAsyP_{1-y}), Gallium Indium Arsenide Antimonide (Gaₓln₁₋ₓAsySb_{1-y}), Gallium Nitride (GaN), Aluminum Nitride (AIN), Indium Nitride (InN), wherein x and y are positive integers. Preferably, the semiconductor material comprises a typical solar cell material such as Si, Ge, or GaAs. More preferably, the semiconductor material is a single elemental semiconductor material such as Si, Ge, or C. Most preferably it is Silicon.

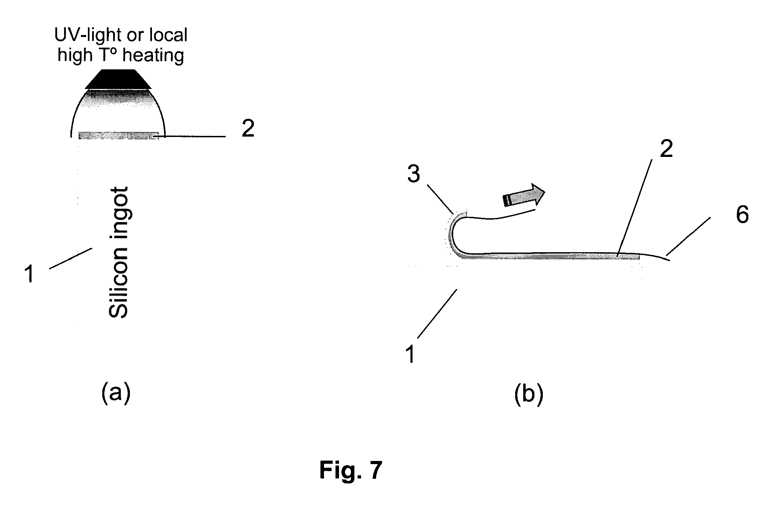

The mother substrate can be, but is not limited to, a wafer, an ingot, a brick or a block. This is illustrated in Fig. 7(a).

In embodiments according to the present invention the material can be amorphous material or can be crystalline material. It can be for instance Nanocrystalline, Micro crystalline, Polycrystalline, Multi crystalline or Mono crystalline. Crystals are referred to herein based on their grain sizes, as provided in Table 1. The term "crystalline silicon" refers to silicon of all crystal types. Materials with grain sizes bigger than the thickness of the thin substrate released can be advantageous for solar cell applications because they reduce the density of grain boundaries which are known to be recombination centers. Materials with grain sizes smaller than the dimension of the main surface of the substrate can be advantageous for solar cell applications since they are less expensive than materials with bigger grains, and since the diminution in performances for solar cells obtained on these materials can be limited compared to the diminution of the cost.

**Table 1**

| Grain size of silicon crystal | Name |
|---|---|
| Atomic size | Amorphous |
| <10 nm | Nanocrystalline |
| <0.1 µm | Micro crystalline |
| <100 µm | Polycrystalline |
| <10 cm | Multi crystalline |
| > 10 cm | Mono crystalline |

In preferred embodiments the first main surface of the mother substrate is flat. The first main surface can be concave shaped. It is believed that a concave shaped main surface can favour the release of the thin substrate. Alternatively the first main surface can be convex-shaped. It is believed that a substrate with a pre-determined or tailored convex shape can lead to the release of a flat subsystem (comprising the thin substrate under stress and if present stress-inducing layers, which are explained later in the text). The first main surface can be texturised or not.

In certain embodiments according to the present invention, the mother substrate can be chosen such that it is bent or elastically deformed when inducing the predetermined amount of stress in at least a portion of the mother substrate.

This can be achieved by providing a mother substrate with a predetermined thickness which is low enough. For typical materials as for instance silicon this thickness can then be preferably smaller than 300, 200, 100 microns. In this case, the thickness of the produced thin substrate may be between 10 µm and 100 µm.

It is believed that providing a mother substrate that is bent or elastically deformed when inducing the predetermined amount of stress can favour the release of the thin substrate.

In other embodiment the mother substrate is chosen such that it is essentially not bent or deformed when inducing the predetermined amount of stress in at least a portion of the mother substrate.

This is achieved by providing a mother substrate with a predetermined thickness which is high enough. For typical materials as for instance silicon the thickness of the mother substrate can then be preferably larger than 100 , 200, 300, 400, 500, 600, 750 microns, 1 mm, 1 cm, 10 cm.

It is believed that providing a mother substrate that is not significantly bent or elastically deformed when inducing the predetermined amount of stress can favour the conservation of the integrity of the mother substrate after the release of the thin substrate and the use of the mother substrate several times for successive thin substrate releasings. The mother substrate can for example be an ingot, and the so-called thin substrate can be a typical substrate for semiconductor processing, such as e.g. a 600 or 750 µm thick substrate.

The thin substrate can have a thickness below 750, 600, 500, 400, 300, 200, 150, 100, 90, 80, 70, 60, 50, 40, 30, 20, 10 microns, depending on the thickness of the mother substrate. The thin substrate can have a thickness larger than 10 nm, 100 nm, 1 µm, 5 µm. Thin substrates below 300, 200, 150, 100, 90, 80, 70, 60, 50, 40, 30, 20, 10 microns are particularly interesting to be obtained by this method since the standard method for obtaining such thin substrates is wire sawing, which induces a kerf loss in the range of 200 microns lost for one wafer sawn. In addition, for photovoltaic applications such as solar cell applications, it is also very interesting to obtain thin substrates thinner than what is currently available: the price of a commercially available silicon solar module is driven by the cost of the semiconductor material which represents by itself almost half of the production cost of the finished module. Furthermore, independently of the material price, with currently industrially achievable surface recombination velocities (~200 cm.s⁻¹), the optimum thickness for achieving the highest efficiency on a crystalline silicon solar cell is usually considered to be below 100 microns, in the surroundings of 50 microns, a lot thinner than the currently available 250 µm-thick wafers. Moreover below a few tens of microns, silicon proves to become flexible. Encapsulated in a suitable and flexible material, it can provide a building block for new applications requiring lightweight, flexible, high efficiency solar modules, such as energy generating clothes, ambient intelligence devices, solar vehicles, etc.

The thin substrate thickness can have a thickness larger than 10 nm, more preferably above 100 nm, 1 micron, 5, 10, 20, 30, 40, 50, 60, 70, 80, 90, 100 microns. The thin substrate is more resistant to breakage by manipulation, and thus easier to process than a free standing substrate if it is thicker. For thin substrates thinner than 10 microns, it can be preferable to attach them to a carrier substrate while processing them.

In preferred embodiments the induced stress is tensile stress. In preferred embodiments the induced stress is at least locally tensile. With "locally" is meant "in the region where the crack should occur". In preferred embodiments the induced stress is locally mainly shear stress. In preferred embodiments the induced stress is at least locally a combination of tensile and shear stress.

In preferred embodiments according to the present invention the stress is applied such that its direction evolves towards a direction which does not coincide with any crystal plane, during the release.

In preferred embodiments according to the present invention the stress is applied such that its direction evolves towards a direction which coincides with a predetermined crystal plane. It is believed that applying the stress so that a crack generated by the stress has a direction which evolves towards a weak plane (being such a predetermined crystal plane) in the substrate can favour the release of the thin substrate. A weak plane can be a plane which is naturally weaker (a plane A is weaker than a plane B if A comprises a smaller atomic bond density than plane B) than other crystalline planes in the material of the substrate (e.g. (111) plane in silicon can be considered a weak plane). Using a naturally weak plane, advantageously as weak as possible, can be preferable since it increases the releasing efficiency of the thin substrate when stress is induced. This also removes or reduces the possible need for production of local weaknesses. A weak plane can be a plane artificially weakened (e.g. by ion implantation, porous layer, crystalline mismatch). Using an artificially weakened plane can be preferable since it can give a good control of the thickness of the thin substrate released.

In preferred embodiments according to the present invention the mechanical stress is applied such that the direction of the crack generated in the substrate by applying the stress evolves towards a direction essentially parallel to the first main surface of the mother substrate. For processing the thin substrate into a solar cell, the thin substrate has preferably a flat shape.

In advantageous embodiments according to the present invention the released thin substrate is not completely relieved from the exerted stress when being released, resulting in a curling of the released thin substrate. It is believed that the (at least local) curling of the released thin substrate favours the propagation of the crack in a direction parallel to the main surface. It is believed that a curled thin substrate can be used in specific applications for which this shape can be preferable (e.g. at the focus of a parabolic mirror for concentrated photovoltaics applications).

In preferred embodiments according to the present invention the stress is induced by selecting a set of materials, comprising at least 1 material, and a set of predetermined stress actuation mechanisms, comprising at least one stress actuation mechanism, producing e.g. by means of screen printing, spinning, depositing, growing, evaporation depositing, bonding, or sputtering, a stack of the set of layers of the set of stress induction materials on the first main surface of the mother substrate, and actuating the set of stress actuation mechanisms such that the thin substrate is released from the mother substrate.

The stress actuation mechanisms part of the set of stress actuation mechanisms can be actuated sequentially or contemporarily.

The production of the stack of layers can advantageously be performed under predetermined conditions. Such predetermined conditions can be chosen as conditions in which the released thin substrate will typically be used. The parameters defining these conditions can be, but are not limited to, temperature, pressure, electromagnetic (for instance UV) exposure, electrostatic or magnetostatic field exposure, atmosphere environment.

Advantageously a predetermined condition can be room temperature and/or atmospheric pressure. Moreover it can relate to environmental conditions as limited electromagnetic (e.g. UV) exposure, limited electrostatic or magnetostatic field exposure, ambient atmosphere environment.

The stress can be induced by varying at least one of the parameters which determine the predetermined conditions. A preferred embodiment is illustrating this concept; if the production of the stack of layers is done in ambient conditions (typically, but not only, room temperature and atmospheric pressure), after releasing and placing the thin substrate in these ambient conditions, the shape of the thin substrate is likely to reproduce the shape of the main surface of the mother substrate and is therefore easily controllable.

In preferred embodiments according to the present invention, the bond between 2 following or adjacent layers of the stack layers of stress induction materials and between the first layer and the mother substrate is strong enough to withstand the induced mechanical stress.

In preferred embodiments according to the present invention, the stack of layers is able to withstand the predetermined amount of stress without breaking. In embodiments of the present invention, the stack of layers is able to withstand the predetermined amount of stress without plastic deformation.

In preferred embodiments according to the present invention, the stack of layers on itself is flexible. It is believed that the (at least local) curling of the stack of layers favours the propagation of the crack generated in the mother substrate by inducing the predetermined amount of stress, and favours this propagation in a direction parallel to the main surface of the mother substrate.

In preferred embodiments according to the present invention, the stress is induced by creating a different expansion or contraction of the stack of layers with respect to the mother substrate, the expansion or contraction of the stack of layers being respectively smaller or larger than the expansion or contraction of the mother substrate. In preferred embodiments this condition is fulfilled for that layer of the stack which is in physical contact with the mother substrate (called bottom layer, which can be a contact layer or support layer as explained further on). In embodiments according to the present invention the bottom layer may be a metal layer. It can for example be a Li, Na, K, Rb, Cs, Be, Mg, Ca, Sr, Ba, Sc, Y, Ti, Zr, Hf, V, Nb, Ta, Cr, Mo, W, Mn, Re, Fe, Ru, Os, Co, Rh, Ir, Ni, Pd, Pt, Cu, Ag, Au, Zn, Cd, Hg, Al, Ga, In, Ti, Sn, Pb, Bi layer, preferably a Zn, Fe, Ag, Al, Pb, Au, Cu, Ti, Pd layer, since the latest are among the most common metals. It is preferably an Ag layer since the mechanical properties (strength, young modulus, elasticity, yield point) of Ag can be favourable for releasing the thin substrate. The thermal expansion coefficient (TEC) mismatch between the mother substrate and the bottom layer can be larger than 0, preferably larger than 0.5, 1, 2, 3, 4(*x*10⁻⁶*K*⁻¹), advantageously larger than 5, 10, 15 (*x*10⁻⁶*K*⁻¹).

Each layer material in the stack can be a polymer. Each layer material in the stack can be thermosetting polymer which provide the advantage of being easily deposited (e.g. by spin coating or screen-printing), and easily cured (thermally or under UV exposure). Each layer material in the stack can be a polymer with a different thermal expansion coefficient than the mother substrate, e.g. silicon (e.g. SU-8 photoresist). The TEC mismatch between the stack and the mother substrate can be larger than 0, preferably larger than 0.5, 1, 2, 3, 4, advantageously larger than 5, 10, 15 *(x10⁻⁶K⁻¹) .*

In advantageous embodiments according to the present invention, the stack of layers is at least partially cooled (preferably via the top layer, i.e. including the top layer).

In embodiments according to the present invention, the mother substrate is heated. A non homogenous thermal treatment can favour the expansion or contraction difference between the mother substrate and the stack of layers.

In preferred embodiments according to the present invention, the stack of layers has a first thermal expansion coefficient (TEC), and the mother substrate has a second thermal expansion coefficient, the first TEC being larger than the second TEC. In the method, a general temperature step is applied for inducing the predetermined amount of stress in a least a portion of said mother substrate (i.e. to the whole composite substrate, comprising stack of layers and mother substrate), the temperature step being negative (decrease in temperature).

In preferred embodiments according to the present invention, the stack of layers has a first thermal expansion coefficient (TEC), and the mother substrate has a second thermal expansion coefficient, the first TEC being smaller than the second TEC. In the method, a general temperature step is applied for inducing the predetermined amount of stress in at least a portion of said mother substrate, the temperature step being positive (increase in temperature).

In preferred embodiments according to the present invention, the stack of stress induction materials comprises essentially 2 layers of stress induction materials. These 2 layers can both be metal layers. These layers can be chosen and arranged such that a bimetal effect is achieved under a temperature step. In preferred embodiments according to the present invention, the bottom layer or first layer of the stack comprises Ag and a second layer of the stack, on top of the first layer, comprises Al.

The thermal expansion coefficients of Si, Ag and Al are respectively about 4.6x10⁻⁶ *K*⁻¹,20x10⁻⁶*K*⁻¹, 24x10^{*-*6}*K*⁻¹

In preferred embodiments according to the present invention the set of stress induction layers comprises a piezoelectric layer and the set of actuation mechanisms comprises applying a DC voltage over the piezoelectric layer.

Other actuation mechanisms are also possible including, but not limited to, any change from the previously defined predetermined, typically ambient, conditions.

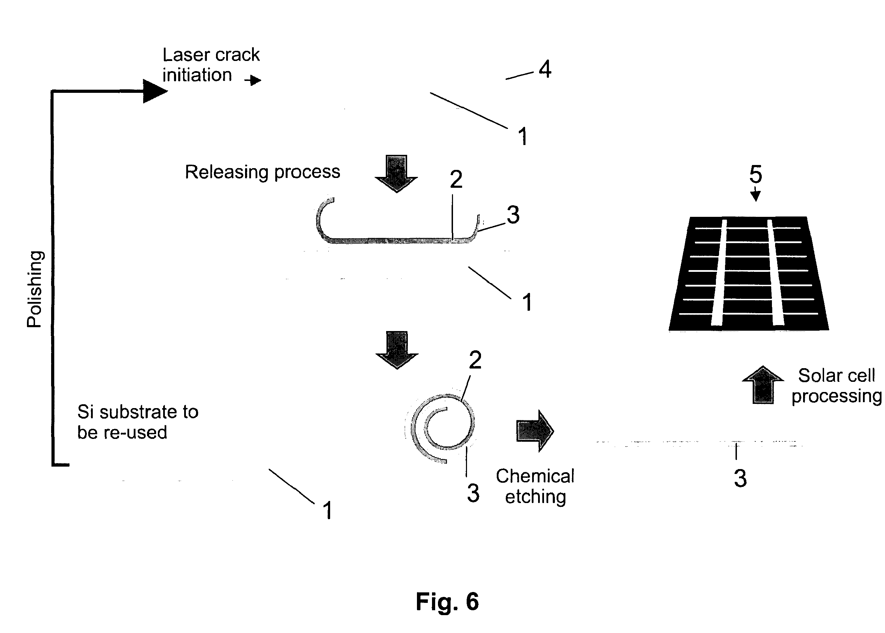

In preferred embodiments, the production of local weaknesses may be performed, e.g. initiator cracks, which are applied at predetermined locations of the mother substrate and before inducing the stress , so as to predetermine the thickness of the thin substrate. See for instance also Fig. 6.

These initiator cracks may be produced by, but not only, laser, by etching or by sawing, by scratching or by cutting. They can be provided on the first main surface. The mother substrate can also have a second main surface, typically substantially parallel with the first main surface and connected with the first main surface by a side surface, and the cracks can be provided on a side surface of the mother substrate.

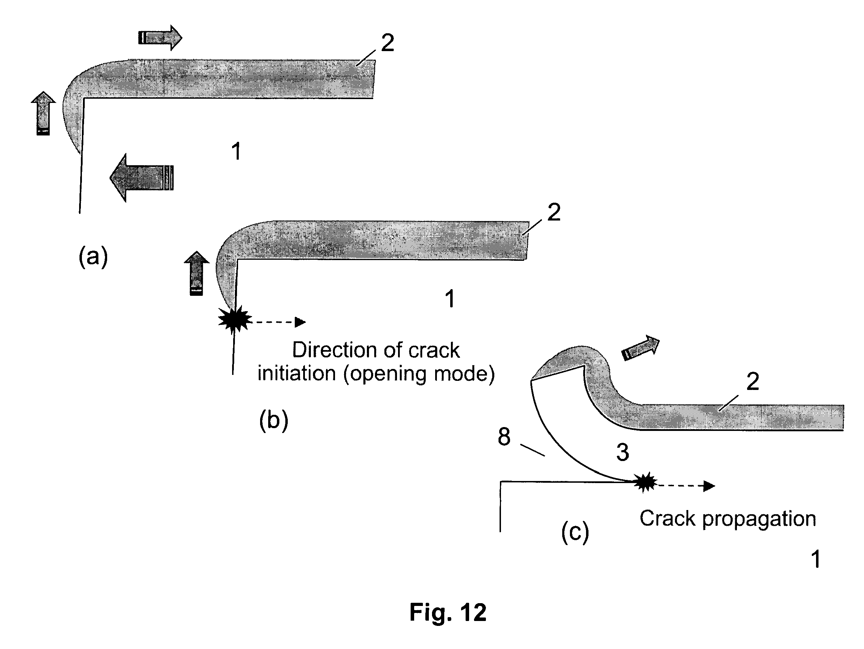

In preferred embodiments, the mother substrate has a side surface and the layer or series of layers of stress induction materials are partially extending on the side surface of the mother substrate. This is illustrated in Fig. 12.

In preferred embodiments, further temporarily bonding the layer or series of layers of stress induction materials to a stretchable carrier substrate can be performed (illustrated in Fig. 7(b)). The stretchable carrier substrate can be chosen such that it is resistant to the series of stress induction mechanisms, and/or to the induced mechanical stress. The stretchable carrier substrate can be used to externally assist the stress application or induction to release the thin substrate.

In preferred embodiments, at least a portion of the layer or layers of stress induction material is removed at predetermined locations, after release of the thin substrate from the mother substrate, hereby releasing (at least partly) the stress from the thin substrate.

In preferred embodiments, the removed portion of the layer or layers of stress induction material corresponds to a grid pattern or other pattern which allows release of at least part of the stress out of the layers of stress induction material and thin substrate.

The remaining portion of the stack of stress-inducing layers can be predetermined or chosen beforehand to contribute not significantly to the stress induced in the mother substrate. Its role can be limited to supporting the thin substrate while the stress has been released. The remaining portion of the stack of layers is the difference between the stack of layers and the removed portion.

The remaining portion of the stack of stress-inducing layers can be predetermined or chosen beforehand to be completely or at least partially transparent to a predetermined radiation spectrum, as for instance the solar spectrum. The remaining portion can then for example serve as a front surface of a photovoltaic device.

The remaining portion of the stack of stress-inducing layers can be chosen beforehand to be conductive and/or provide a good electrical contact with the thin substrate. The good electrical contact of the remaining portion may be created when actuating a stress induction mechanism, as for instance when applying a temperature step.

The removed portion of the stack of stress-inducing layers can comprise only some of the layers of said stack of layers. It can be a certain number of upper layers of the stack. It can comprise a number of layers which includes the lastly produced layer, i.e. the top layer of the stack. It can comprise the top layer of the stack and one or more layers of the stack underlying the top layer, which can be adjacent or in physical contact. It can be a certain number of upper layers of the stack plus a portion of the remaining stack of layers. The remaining stack of layers can comprise the bottom layer of said stack, being the firstly produced layer of said stack.

In a further aspect, a method for repetitively producing a thin substrate of material is disclosed, comprising a repetition of the methods according to any of the previously described embodiments. A repetitive production of thin substrate from the same parent wafer or mother substrate allows the production of thin substrates with very limited kerf loss, and thus is expected to reduce strongly the cost of production of such thin substrates.

The thin substrates produced by the methods according to the previously described embodiments of the present invention can be advantageously used for solar cell production. Both main surfaces of the thin layer or thin substrate can advantageously be used as a front surface of a solar cell, i.e. surface to be illuminated during use. The surfaces present some roughness which can advantageously be used to trap light in the thin device. Such a solar cell production process can be one of the following:
- diffusion of an emitter, shadow evaporation of contacts, annealing, antireflection-coating deposition;
- diffusion of an emitter, SiNx deposition, contact definition by patterning a photoresist, evaporation and lift-off of the exceeding metal parts, annealing; or
- deposition of a doped a-Si emitter, deposition of a conductive oxide layer, contact shadow evaporation, annealing.

In a further aspect, a composite stack of layers is disclosed, comprising a thin substrate of material, e.g. semiconductor material, the layer of material having a thickness smaller than 100 microns and larger than 100 nm, and at least one layer of a stress inducing material attached to the layer of material, characterized in that the composite stack of layers is rolled up. It can for example be rolled up with at least a quarter, at least a half or at least one full winding. Intermediate degrees of winding are of course also possible, depending on the materials used and the stress remaining.

### Description of the figures

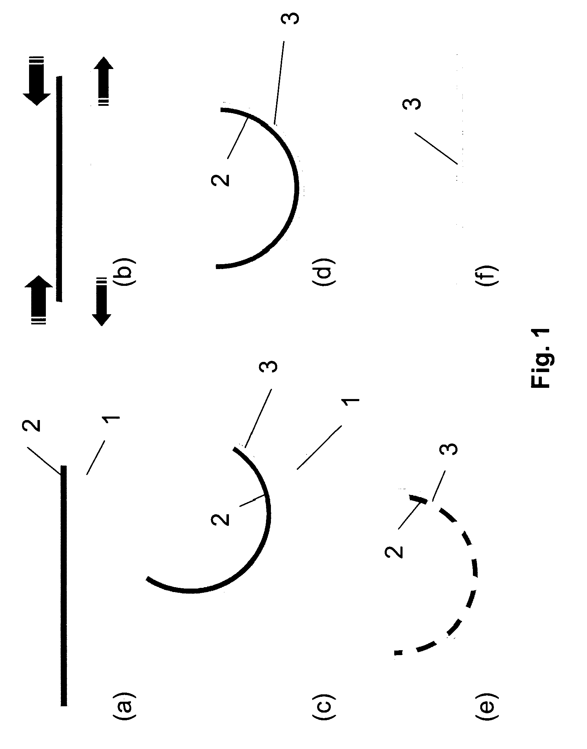

Fig. 1 shows embodiments according to the present invention: (a,b) a stress distribution is induced by depositing a stack of stress-inducing layers (2, shown as a single layer, but optionally comprising a number of sublayers) on a substrate (1). (c) When the stress locally exceeds the toughness of the substrate material a crack propagates parallel to the main surface. Meanwhile detaching, because of the excellent bonding of the stack of layers to the substrate, the stack of layers rips off part of the substrate, a thin substrate (3). (d) Once released the composite system of thin substrate and stack of layers still exhibits some internal stress and is therefore bending. (e,f) Removing at least a predetermined part or the whole stack of stress-inducing layers releases the stress and unrolls the thin substrate, leaving a flat and stress-free thin substrate.
Fig. 2a shows pictures of a thin silicon substrate released from a multi-crystalline wafer. Fig.2b is a microscope picture of the cross-section of the rolled stack, showing a thin silicon substrate (3) and a bilayer stack of an Ag sub layer 2.1 and an Al sublayer 2.2.
Fig. 3a shows pictures of a thin silicon substrate after metal etching. Fig. 3b shows a microscope picture of the cross-section of the rolled stack. Surface (32) which was in physical contact with the remainder of the mother substrate, shows a rather shiny aspect. The opposite surface, surface (31), which was in physical contact with the stress-inducing layers, displays a rougher, textured aspect.
Fig. 4 is a plot representing the measured current-Voltage (IV) characteristic of a photovoltaic cell which is processed on a released or ripped-off thin substrate in accordance with an embodiment of the present invention.
Fig. 5 further illustrates the mechanism for the described process, according to embodiments of the present invention, the crack (8) initiation and the evolution of its direction are illustrated.
Fig. 6 illustrates embodiments according to the present invention wherein the thickness of the thin substrate can be controlled by for instance creating local weaknesses as e.g. initiator cracks (4) at predetermined locations before inducing said stress, and illustrates the repetitive use of a single parent substrate for the production of a series of thin substrates, which can on their turn be used as a basis for the production of solar cells (5).
Fig. 7 illustrates embodiments according to the present invention, in which the parent wafer or mother substrate is reused:
   (a) applying the process on a semiconductor ingot or block or brick.
   (b) mechanical assistance with a temporarily bonded flexible film (6), e.g. a plastic film, during the process.
Fig.8: Simulation of the change of direction in the crack propagation; this supports Fig. 5 and the corresponding statements.
Fig. 9: compares the process applied on a flat-shaped main surface and the process applied on a cylinder-shaped main surface (e.g. the side surface of an ingot).
Fig. 10 shows a method to obtain a thin substrate without necessarily depositing a stress-inducing layer, according to an embodiment of the present invention.
Fig.11: Reflectivity spectra of both surfaces of the thin substrate obtained by the method described, compared to the reflectivity of mirror-polished and chemically isotextured.
Fig. 12: illustration of embodiments according to the present invention wherein the series of layers of stress induction materials are partially extending on the side surface of the mother substrate.

### Description of illustrative embodiments

The present invention will be described with respect to particular embodiments and with reference to certain drawings but the invention is not limited thereto but only by the claims. The drawings described are only schematic and are nonlimiting. In the drawings, the size of some of the elements may be exaggerated and not drawn on scale for illustrative purposes.

Furthermore, the terms first, second, third and the like in the description and in the claims, are used for distinguishing between similar elements and not necessarily for describing a sequential or chronological order. It is to be understood that the terms so used are interchangeable under appropriate circumstances and that the embodiments of the invention described herein are capable of operation in other sequences than described or illustrated herein.

Moreover, the terms top, bottom, over, under and the like in the description and the claims are used for descriptive purposes and not necessarily for describing relative positions. It is to be understood that the terms so used are interchangeable under appropriate circumstances and that the embodiments of the invention described herein are capable of operation in other orientations than described or illustrated herein.

A new method is here proposed to produce thin substrates of a material. The principle is the following: a predetermined stress field (predetermined in value as well as in orientation) is applied to a mother substrate. This stress locally exceeds the toughness of the material and will therefore induce a crack. Once the crack is initiated, it can propagate into the mother substrate. As a result of the crack, some material is released (first locally) from the mother substrate, leading to a modification of the stress distribution over the mother substrate. The change in stress distribution (and in particular orientation) triggers a change in the direction of propagation of the crack. The stress distribution is indeed applied such that the direction of crack propagation converges towards a direction parallel to the main surface of the mother substrate. Whatever the initial orientation of the first crack initiation (including the situation where the crack initiation is performed on purpose in a direction parallel to the main surface), the crack propagates parallel to the main surface of the mother substrate, and the thin substrate that is released from the mother substrate has a relatively homogeneous thickness (within a few percents).

This is also illustrated in Fig. 1; a stack of stress inducing layers (2) is produced on the first main surface of the mother substrate, e.g. silicon, (Fig. 1(a)) and the stress induction mechanisms are actuated (Fig.1(b)). As a result of the stress the stack of layers (2) (represented as 1 layer in the figures 1 (a) to (e)) tends to detach from the mother substrate, e.g. silicon. While detaching, because of the excellent adhesion or bonding of the stack of layers (2), e.g. metal layers, to the mother substrate, e.g. silicon substrate, the stack of layers rips off some silicon, i.e. a thin substrate 3, from the underlying wafer (see Fig.1 (c)). Because of the remaining mechanical stress, the released subsystem (comprising the layer stack 2 and thin substrate 3) is rolled-up (see Fig.1 (d)). At least partially removing the stress inducing stack (see Fig.1 (e)) releases the stress and unrolls the thin substrate 3, leaving a flat and thin ripped-off silicon substrate (see Fig.1 (f)).

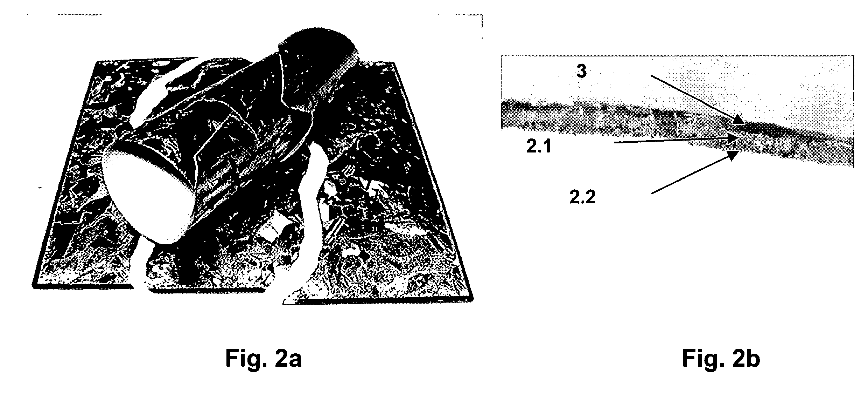

Fig. 2a shows pictures of a thin silicon substrate released from a multi-crystalline wafer. Fig.2b is a microscope picture of the cross-section of the rolled stack, showing a thin silicon substrate (3) and a bilayer stack of an Ag sub layer 2.1 and an Al sublayer 2.2.

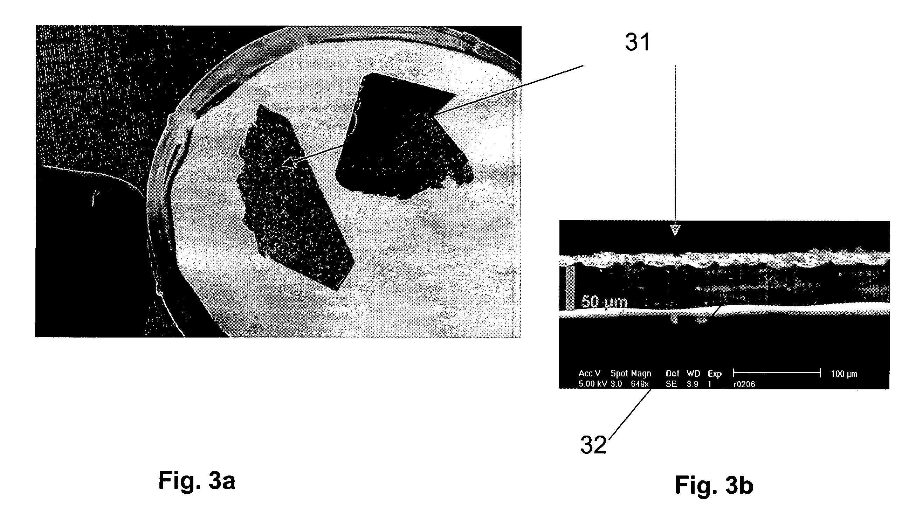

Fig. 3a shows pictures of a thin silicon substrate after metal etching. Fig. 3b shows a microscope picture of the cross-section of the rolled stack. Surface (32) which was in physical contact with the remainder of the mother substrate, shows a rather shiny aspect. The opposite surface, surface (31), which was in physical contact with the stress-inducing layers, displays a rougher, textured aspect.

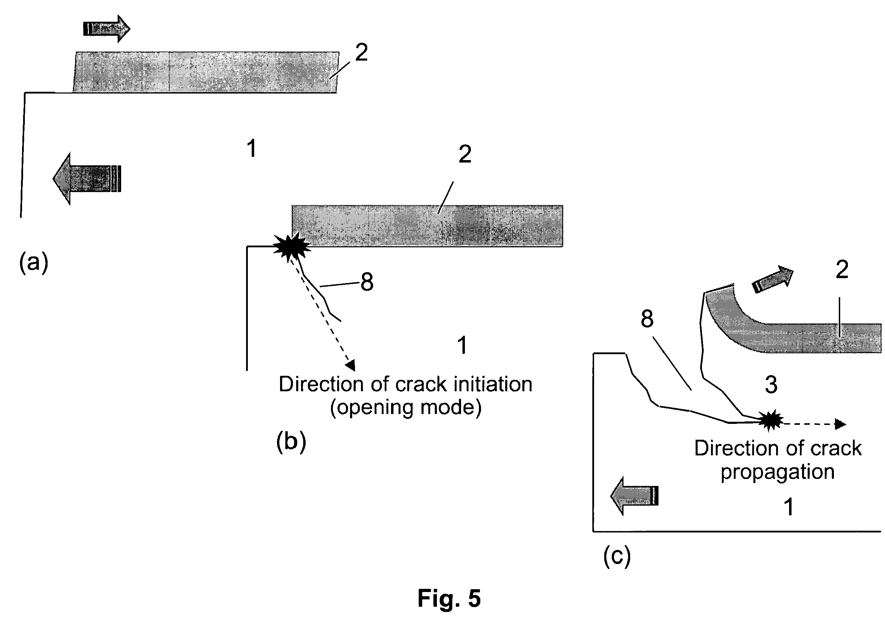

Fig. 5 further illustrates the mechanism for the described process, according to embodiments of the present invention, the crack (8) initiation and the evolution of its direction is illustrated.

It is believed that other materials can be used, such as other semiconductors, other crystals, but also other bulk materials.

### Depositing layers of different thermal expansion coefficients

In order to obtain the desired stress distribution a set of layers, comprising at least 1 layer, of materials able to induce stress in the substrate is screen-printed on the parent substrate (in this case a 300-µm-thick Cz wafer). In this case the stress actuation mechanism is the difference in thermal expansion coefficient (TCE) between the printed layers and silicon.

The material was bonded to the substrate at high temperature (~800°C) in a belt furnace. During cooling down, the difference in TCE induces stress in the system. When the stress locally exceeds the toughness of silicon, a crack initiates, releasing locally from the substrate a sub-system composed of the set of stress inducing layers and a portion of the substrate. In this case, the maximum stress point is at the interface between the silicon and the set of stress-inducing layers, and the opening mode (perpendicular to the maximum stress direction) exhibits an oblique angle with regards to the main surface.

Because the portion released from the mother substrate is bonded to the stress inducing set of layers, the stress is not completely relieved from the subsystem once ripped off. The set of layers may be under tensile stress, whereas the piece of silicon is under compressive stress, or vice versa. This particular local stress distribution leads to the curling of the subsystem, similarly to a bimetal. The curling of the released subsystem continuously changes the stress distribution during the releasing process. This continuous change is such that the crack propagation converges towards a direction parallel to the main surface of the substrate. Fig. 5 describes the releasing process.

Using a finite-element-analysis modelling tool, the stress distribution triggered by a 50-µm-thick layer of pure aluminium on a 300-µm-thick silicon substrate was calculated. The point of maximum stress is indeed calculated to be at the interface between the silicon and the stress-inducing layer, at the edge of the layer stack. Knowing the different stress components (including shear stress), the opening mode was calculated, perpendicular to the direction of principal stress.

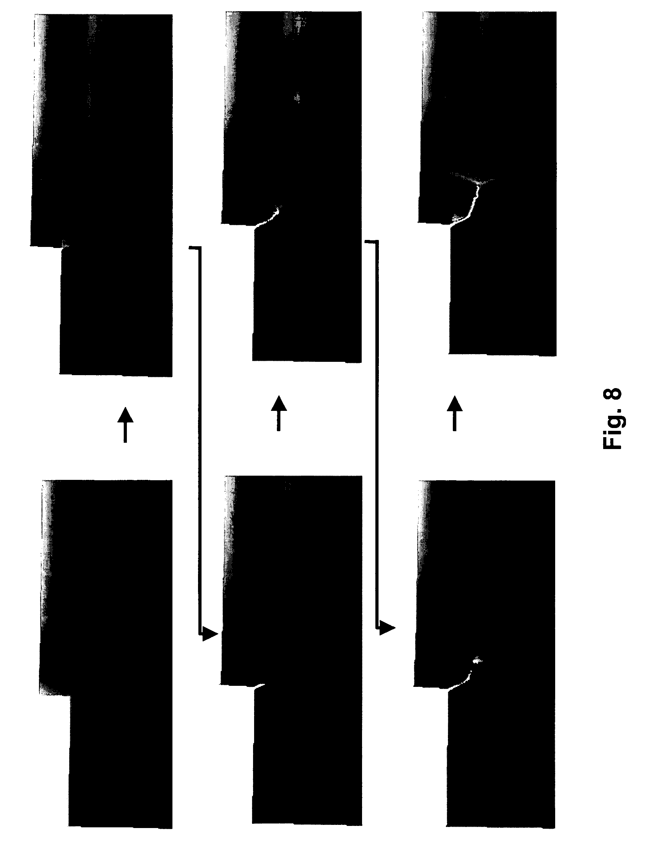

The structure under study was numerically "broken" (by redrawing the structure and locally modifying the nodes) in order to insert a crack in the direction of the opening mode, over a distance d. The stress distribution was calculated again and it was found that the point of maximum stress is at the end of the crack. The opening mode was calculated again and the crack was manually propagated, point after point, in the direction each time calculated. The distance d is chosen sufficiently small so that the resulting crack trajectory does not depend significantly on d, and sufficiently large to limit the computation time. The result of the computation is shown on Fig. 8 after 20 points calculated. d is chosen to be 0.2 µm. The direction of propagation of the crack evolves towards a direction parallel to the main surface.

In this case the actuating mechanism is a thermal load in combination with the thermal expansion coefficient difference between silicon and the stress-inducing layers. The stress-inducing materials are metal pastes. It is believed that the stack can comprise non-metallic layers, like for instance polymer materials. For instance, it is possible to use SU-8 photoresist which provides also a good adhesion to silicon, and displays a thermal coefficient mismatch as well.

The actuation mechanisms are not limited to thermally induced shape changes. The stress can also be obtained by applying a change in the environment of a material whose shape is affected by the external conditions. This material can be sensitive to a change of the environment regarding: electrostatic (piezoelectric), magnetostatic (magnetic material), electromagnetic (UV sensitive, for instance), chemical or pressure conditions.

The ambient condition state of the released subsystem is in this case a rolled up composite stack of layers comprising the set of stress-inducing materials and the thin silicon substrate. It can be advantageous to bond the stress-inducing layer to the mother substrate at room temperature (or more generally under standard conditions), to obtain the release by e.g. cooling down the whole system, or heating up the mother substrate selectively from the set of stress-inducing material (more generally by deviating from standard conditions), so that the released subsystem is only temporarily in a rolled-up state, and recovers its flat shape when standard conditions are applied again.

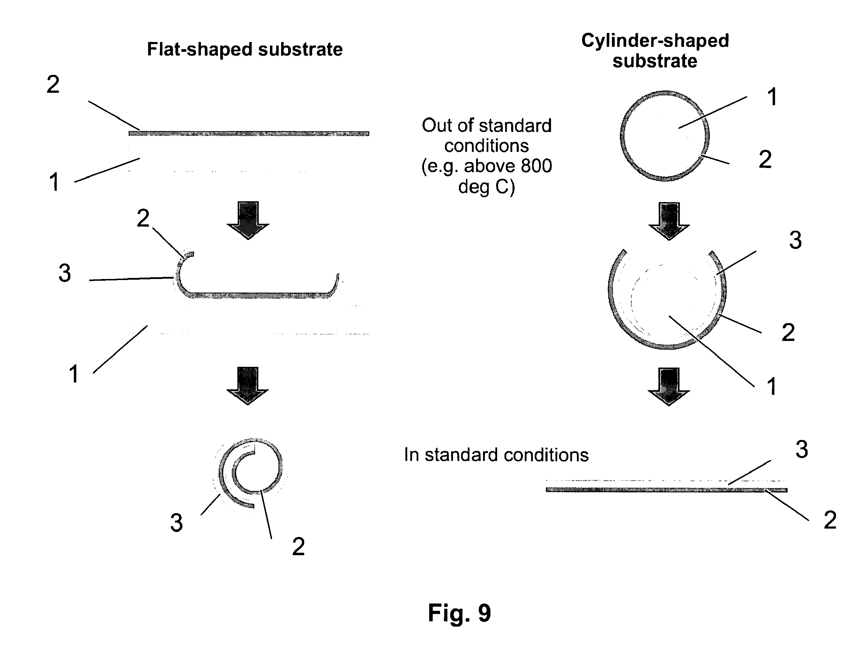

In this case the mother substrate is a flat wafer but this is not a requirement. The method has also been successfully applied on textured wafers and can be applied on non plane surfaces. In particular it is interesting to consider a cylinder-shaped mother substrate where the stress-inducing set of layer is deposited on the outside curled surface. The cylinder curvature can be customized so that the released subsystem is flat under standard processing conditions (room-temperature). This process is compared to the process applied on a flat-shaped substrate on Fig. 9. It can also be interesting to consider a concave substrate since the direction of the stress induced by the stress-inducing layers is believed to play a role in the release of the thin substrate.

It can be advantageous to apply the method to a mother substrate that can withstand the stress distribution induced during the releasing process without breaking. In this case, the mother substrate can be used several times to produce an important number of thin wafers with only limited material loss.

The method was successfully applied on a multi-crystalline substrate (grain size in the order of 1 cm). This means that the macroscopic propagation of the crack is independent of the crystal planes.

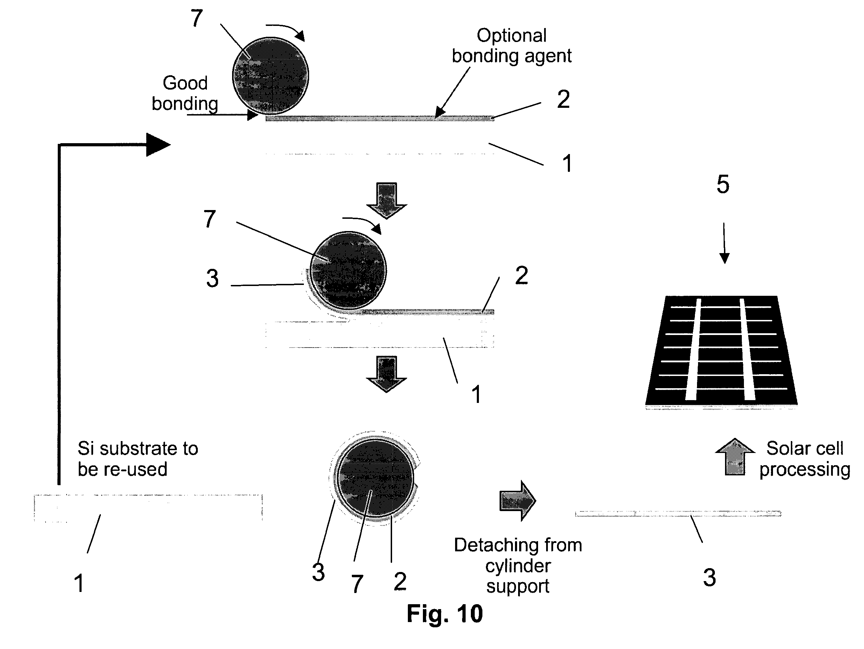

Depositing a stress-inducing material is not a requirement. A good bonding (which is strong enough to withstand the induced mechanical stress) of the mother substrate to cylinder-shaped apparatus is able to induce a stress distribution compatible with the releasing of a thin substrate. Depositing a bonding agent on top of the mother substrate can in this case help applying the stress distribution with the cylinder-shaped apparatus without breaking the thin substrate. This method is schematized on Fig. 10. Hereby a rolling movement of a roller (7), which is bonded to the first main surface of the mother substrate by means of a bonding agent, causes the rip-off of a thin substrate (1). This method can be combined with other methods according to the present invention. It can for instance be combined with a stack of at least one but typically more layers which can be actuated by a series of actuation mechanisms, which can be actuated contemporarily with the rolling movement of the roller. The different actuation mechanisms can be also applied before the movement of the roller, but up until a level which may not suffice to rip-off a thin substrate. The bonding agent can be for instance SU-8.

The bonding agent can be applied on the roller, or on the first main surface, or on both.

The dimensions of the roller are preferably such that a ripped-off thin substrate doesn't cover a complete circumference of the roller, avoiding self-overlap of the thin substrate.

### From the parent substrate to a thin substrate

After being released from the mother substrate, the thin silicon substrate, in embodiments of the present invention, is still bonded to the stress-inducing set of layers. The released subsystem is thus a rolled-up stack comprising the (silicon) thin substrate and the stress inducing set of layers. This subsystem can be as large as the mother substrate main surface. Square thin substrates rolled-up of 100 cm² have been achieved. The stress-inducing set of layers was chemically etched and the thin silicon substrate remains thus flat and stress-free. Fig. 1 gives an overview of the method according to embodiments of the present invention, from the mother substrate 1 to a thin substrate 3.

in this case a double layer consisting of a screen-printed fire-annealed (over 800 deg C, for a few seconds) layer of commercially available Ag paste directly on the Si substrate, and on top of that, a screen-printed fire-annealed (over 800 deg C, for a few seconds) layer of commercially available Al paste is used as stress-inducing set of materials 2.

In order to remove the set of stress-inducing layers 2 after releasing, the subsystem was dipped subsequently in a warm HCI solution, and in a mixture of HCI and HNO₃.

Free-standing contamination-free (checked with TXRF) thin silicon substrates up to 10 cm² have been obtained, with a thickness of 50 µm +/- 10 µm. Fig. 3a shows an example of a stress-free silicon thin layer after etching of the stress-inducing layers. In Fig. 3b a SEM cross-section of the thin silicon substrate is shown. The thickness is approximately 50 µm. There is no a priori limitation in size nor in thickness of the thin substrates that can be produced with this method.

If the resulting subsystem is flat under standard conditions of processing (most of the time room temperature), the stress-inducing set of layers can be used as a support to the thin layer and the subsystem can be processed as it is.

If the set of layers is conductive and makes a good electrical contact with the thin substrate of silicon, it can be used as one of the electrical contacts of the device.

It can be convenient to deposit first a bottom layer that does not induce stress and is not etched in the chemical solution. This can be used as electrical contact and/or support layer for handling the this substrate, e.g. thin layer of silicon, after etching the stress-inducing layers. If this support layer is transparent, a back-contact process can be applied and the support layer can be used as a front surface of the processed solar cell. The same holds also for a stress-inducing layer partly removed to relieve mostly the stress and allow further processing, but not completely removed to use the remaining part as supporting layer or substrate and/or electrical contact.

The rolled shape of the thin substrate can be advantageously used in specific applications for example at the focal point of a parabolic mirror. In this case the metal stress-inducing layers can provide electrical contact.

A double layer of metal pastes has been used in the example described. The process was also successful with a double layer of Ag paste (no Al paste). Also one layer of an optimised material (with predetermined or tailored mechanical characteristics) can be used to obtain the same result.

### Characterization of the thin substrate

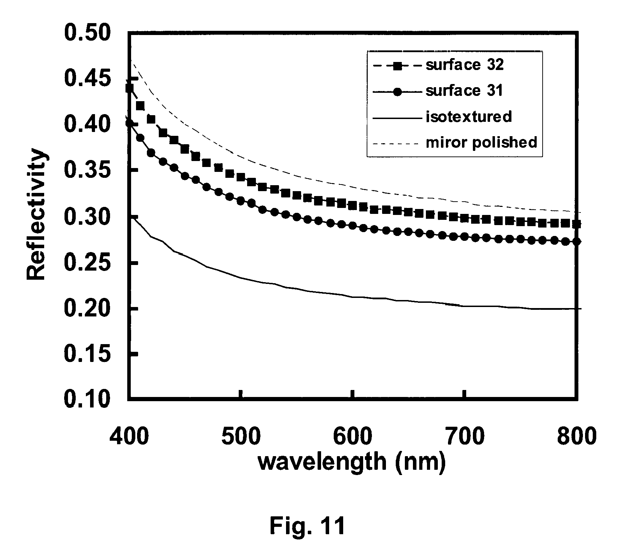

After etching the stress-inducing layers, the two surfaces of the thin substrate have a very different aspect. In Fig. 3a and 3b, surface (32) which was in physical contact with the remainder of the mother substrate, shows a rather shiny aspect. The opposite surface, surface (31), which was in physical contact with the stress-inducing layers, displays a textured aspect.. In Fig. 11 the reflectivity spectra of both surfaces after removal of the stress-inducing layers is shown. We also plot for comparison on the same graph the reflectivity spectra of a mirror-polished silicon wafer, as well as of an acidic-textured (isotextured) wafer. The spectra of the thin silicon substrate lie between the two references, showing that the texturing resulting from the process traps some light into the thin substrate and can be advantageously used on the front side for photovoltaic applications. Surface (31) traps more light than surface (32). For surface 32 the roughness is believed to arise from stress distribution during the release and/or preferential plane fracture. The plane can be chosen to tune the roughness according to the need: as rough as possible for better light trapping if this surface is used as the front side of a solar cell, as smooth as possible for easier surface passivation if it is used as the rear surface of a solar cell. For surface 31 the roughness is believed to arise from the different chemical treatment that the sample underwent; metal - silicon alloying and/or chemical etching of the metals.

### Fabrication of a solar cell

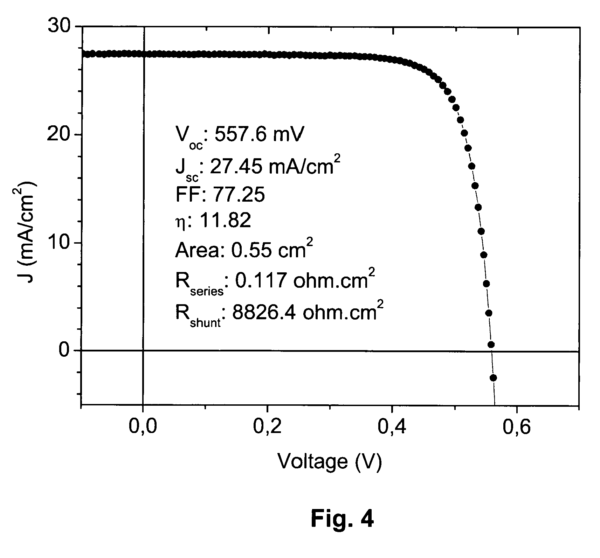

We can use the thin substrate of silicon produced by the method described above to fabricate a solar cell. The layer is cleaned in a mixture of HCl and H₂O₂, then in a mixture of H₂O₂ and H₂SO₄, and finally shortly dipped in HF to remove the oxide formed in the previous bath. From these clean samples, several processes can be applied:
- Simple diffusion process: deposition of a P-rich oxide, P-diffusion at high temperature (above 800°C), metal evaporation for front (with a shadow mask), and back contacts, annealing of the contacts, ZnS/MgF₂ antireflection-coating (ARC) deposition, edge saw dicing. The result of the best cell obtained so far with this very simple cell process is given in table 2.
- Free-standing Monocrystalline Silicon (FMS) process: deposition of a SiNx layer serving for passivation as well as for ARC, lithography to define the front contact, metal evaporation, metal lift-off, evaporation of the rear contact , annealing, edge saw dicing. The details of this process are presented elsewhere [H. Kim et al., "Progress in thin film free-standing monocrystalline silicon solar cells", Thin Solid Films, Elsevier, 2005]. The result of the best cell obtained so far with this cell process is given in table 2 and Fig. 4.
- HIT emitter process: deposition of an n+-doped amorphous silicon layer, deposition of a conductive oxide layer serving as well as an ARC, evaporation of front and back contact with subsequent annealing, edge saw dicing. The details of this process are presented elsewhere [L. Carnel et al. "Perspectives for a-Si/c-Si Heterojunction Solar Cells with p or n Type Base" 31st IEEE PVSC, pp. 1157-1160 (2005)]. The result of the best cell obtained so far with this cell process is given in table 2.

**Table 2**

| Process | Area (cm2) | Jsc (mA.cm-2) | Voc (mV) | FF (%) | Efficiency (%) |
|---|---|---|---|---|---|
| Simple diffusion | 0.73 | 21.79 | 552.3 | 59.0 | 7.10 |
| FMS process | 0.55 | 27.45 | 557.6 | 77.25 | 11.82 |
| HIT emitter process | 1.00 | 26.69 | 549.9 | 67.82 | 9.95 |

## Claims

1. A method for producing a thin substrate (3) with a thickness below 750 microns, comprising
a. providing a mother substrate (1), said mother substrate having a first main surface;
b. inducing a predetermined amount of stress in at least a portion of said mother substrate, said portion comprising said thin substrate, said induced stress being locally larger than the toughness of said mother substrate;
such that said thin substrate (3) is released from said mother substrate (1).

2. A method according to claim 1, wherein said mother substrate is a bulk or homogeneous substrate.

3. A method according to any of the preceding claims, wherein said mother substrate is chosen such that it is bent or elastically deformed when inducing said predetermined amount of stress in at least a portion of said mother substrate.

4. A method according to any of claims 1 to 3, wherein said mother substrate is chosen such that it is essentially not bent or deformed when inducing said predetermined amount of stress in at least a portion of said mother substrate.

5. A method according any of the preceding claims, wherein said stress is applied such that its direction evolves towards a direction inclined with respect to any crystal plane, during said release.

6. A method according to any of the previous claims, wherein the stress is applied such that a crack generated in the mother substrate has a direction which evolves towards a direction which coincides with a predetermined crystal plane.

7. A method according to any of claims 5 or 6, wherein the stress is applied such that a crack generated in the mother substrate has a direction which evolves towards a direction essentially parallel to said first main surface of said mother substrate.

8. A method according to any of the previous claims, whereby said released thin substrate is not completely relieved from said exerted stress when being released, resulting in a curling of said released thin substrate.

9. A method according to any of the previous claims, wherein said first main surface is flat.

10. A method according to any of claims 1 to 9, wherein said first main surface is concave shaped.

11. A method according to any of the previous claims, wherein said first main surface is textured.

12. A method according any of the preceding claims, wherein said stress is induced by selecting a set of stress induction materials, comprising at least one material, and a set of predetermined stress actuation mechanisms, comprising at least one stress actuation mechanism, producing a stack of said set of layers of said set of stress induction materials (2) on said first main surface of said mother substrate, and actuating said set of stress actuation mechanisms such that said thin substrate is released from said mother substrate.

13. A method according to claim 12, the stress induction materials comprising at least two layers, wherein the bond between 2 following layers of said stack layers of stress induction materials and between said first layer and said mother substrate is strong enough to withstand said induced mechanical stress.

14. A method according to any of claims 12 or 13, wherein said stack of layers able to withstand said predetermined amount of stress without breaking, and without plastic deformation.

15. A method according to any of claims 12 to 14, wherein said stack of layers on itself is flexible.

16. A method according to any of claims 12 to 15, wherein said stress is induced by creating a different expansion or contraction of said stack of layers and said mother substrate.

17. A method according to claim 16, wherein said stack of layers has a first thermal expansion coefficient, and said mother substrate has a second thermal expansion coefficient, said first thermal expansion coefficient being larger than said second thermal expansion coefficient, and a general temperature step is applied for inducing the predetermined amount of stress in at least a portion of said mother substrate, said temperature step being negative.

18. A method according to any of claims 16 or 17, wherein said stack of layers has a first thermal expansion coefficient, and said mother substrate has a second thermal expansion coefficient, said first thermal expansion coefficient being smaller than said second thermal expansion coefficient, and a general temperature step is applied for inducing the predetermined amount of stress in at least a portion of said mother substrate, said temperature step being positive.

19. A method according to any of the previous claims, further comprising the production of local weaknesses (4) at predetermined locations on the mother substrate, before inducing said stress, to determine the thickness of the thin substrate.

20. A method according to any of claims 12 to 19, wherein said substrate has a side surface and said stack of layers of stress induction materials are partially extending on said side surface of said mother substrate.

21. A method according to any of claims 12 to 20, further comprising, before inducing said mechanical stress, temporarily bonding said stack of layers of stress induction materials to a stretchable carrier substrate (6), said stretchable substrate being resistant to said series of stress induction mechanisms, and/or to said induced mechanical stress.

22. A method according to any of claims 12 to 21, further comprising a step of removing at least a portion of said stack of layers of stress induction material, hereby releasing said stress from said thin substrate.

23. A method for repetitively producing a thin substrate of semiconductor material, comprising a repetition of the method according to any of claims 1 to 22.

24. A composite stack of layers, comprising a thin substrate having a thickness smaller than 750 microns and larger than 100 nm, and at least one layer of a stress inducing material attached to said thin substrate, **characterized in that** said composite stack of layers is rolled up.

25. A composite stack of layers, according to claim 24, further comprising at least a second layer of stress inducing material.
